# EUROPÄISCHE PATENTSCHRIFT

(11) **EP 3 226 013 B1**
(45) Veröffentlichungstag und Bekanntmachung des Hinweises auf die Patenterteilung: **12.05.2021**
(21) Anmeldenummer: 16205355.7
(22) Anmeldetag: 20.12.2016
(51) Int. Cl.: G01R 19/10, H02H 3/10, G01R 19/08, H02H 3/08, G01R 31/50

(54) **DIFFERENZSTROMSENSOR**
DIFFERENTIAL CURRENT SENSOR
CAPTEUR DE COURANT DIFFÉRENTIEL

(30) Priorität: 29.03.2016 DE 102016205101
(43) Veröffentlichungstag der Anmeldung: 04.10.2017
(73) Patentinhaber: Siemens Aktiengesellschaft, 80333 München (DE)
(72) Erfinder: Adlhoch, Manfred, 93170 Bernhardswald (DE)

(56) Entgegenhaltungen:
- US-A- 3 525 903
- US-A- 3 604 982
- US-A- 3 906 476
- US-A- 4 811 153

## Beschreibung

Die Erfindung betrifft einen Differenzstromsensor, einen Fehlerstromschutzschalter und ein Verfahren zum Schutz eines elektrischen Stromkreises.

Differenzstrommessverfahren, insbesondere für Fehlerstromschutzschalter sind allgemein bekannt. Überlicherweise werden hierzu so genannte Summenstromwandler verwendet. Dabei sind zwei oder mehr Leiter, meist Hin- und Rückleiter bzw. Außen- und Neutralleiter in einem Einphasenwechselstromnetz oder alle drei Außenleiter und der Neutralleiter bei einem Dreiphasenwechselstromnetz, durch einen Stromwandler geführt. Gewandelt wird dann nur der Differenzstrom, d.h. ein von Hin- und Rückstrom abweichender Strom, aus den Leitern. Üblicherweise ist die Stromsumme in einem elektrischen Stromkreis gleich null. So können Fehlerströme erkannt werden.

Fehlerstromschutzschalter werden insbesondere für Niederspannungsstromkreise respektive Niederspannungsnetze verwendet. Mit Niederspannung sind Spannungen bis 1000 Volt Wechselspannung oder 1500 Volt Gleichspannung gemeint.

Übliche Summenstromwandler haben den Nachteil, dass diese nicht bei Gleichspannung funktionieren. Auch sind bisher keine gleich- und wechselstromfähigen Summenstromwandler bekannt, die netzunabhängig respektive netzspannungsunabhängig arbeiten.

Im amerikanischen Patent US 3,604,982 wird ein Erdfehlerstrom- und Überlaststrom-Unterbrechungsapparat offenbart. Es betrifft eine Einheit welche die Leistungsmerkmale elektrische Überlast und Erdfehlerstromschutz kombiniert. Ein einzelner Unterbrechungsapparat beinhaltet Überlast-Unterbrechungsspulen und eine Widerstandsspule, welche durch den Ausgang eines Differenztransformators mit Energie versorgt wird. In einer Ausgestaltung arbeitet der Apparat in einem drei-drahtigen, geerdeten Neutral-System. Die Widerstandsspule arbeitet mit beiden Leitungsdrähten, so dass ein Betrieb mit einer zwei-drahtigen Versorgung ohne Modifikationen möglich ist.

Im amerikanischen Patent US 4, 811, 153 wird ein Stromkreisschützer offenbart. Ein magnetisch arbeitender Stromkreisschützer verwendet magnetische Reed-Kontakte, vorrangig ReedSchalter, in Verbindung mit einem Netzwerk von Spulenwindungen, welche in positive Unterbrechungs- und Rücksetzungsaktionen resultieren; Lichtbogenunterdrückung; örtliche und entfernte Unterbrechungsanzeige; Überstrom- und Überspannungsschutz; durchführbar in Wechselspannungs- und Gleichspannungssystemen; entferntes ein- und ausschalten; Unterbrechungszeit von 50 bis 100 *µ*s; kleine Größe; und besonders geeignet zum Schutz von empfindlichen elektronischen Systemen und Instrumenten.

Aufgabe der vorliegenden Erfindung ist es, ein Differenzstromelement, insbesondere für Gleichstromkreise, anzugeben. Diese Aufgabe wird durch einen Differenzstromsensor mit den Merkmalen des Patentanspruchs 1, einen Fehlerstromschutzschalter gemäß Patentanspruch 13 oder ein Verfahren mit den Merkmalen des Patentanspruchs 14 gelöst.

Erfindungsgemäß ist vorgesehen, dass ein Reedschalter respektive Magnetschalter, wie ein Reedkontakt, mit zwei Spulen bewickelt ist.
Da dieser erfindungsgemäße Differenzstromsensor in einem elektrischen Stromkreis, insbesondere Gleichstromkreis, angeordnet ist, heben sich bei gleichen Hin- und Rückströmen, also wenn die Stromsumme null ist, die Magnetfelder der Spulen gegenseitig auf. Ist die Stromsumme ungleich Null bzw. größer als eine erste Stromdifferenz, bewirkt das entstehende Magnetfeld ein schließen des Reedschalters respektive Magnetschalters, so dass gegebenenfalls der elektrische Stromkreis unterbrochen werden kann.

Vorteilhafte Ausgestaltungen der Erfindung sind in den Unteransprüchen angegeben.

In einer vorteilhaften Ausgestaltung der Erfindung weisen beide Spulen die gleiche Windungszahl auf.

Dies hat den besonderen Vorteil, dass eine optimale Symmetrie der beiden Wicklungen in Bezug auf die erzeugten Magnetfelder erreicht wird.

In einer vorteilhaften Ausgestaltung der Erfindung weisen beide Spulen ein elektrisch leitfähiges Material auf, beispielsweise Draht, beispielsweise in runder oder eckiger, wie rechteckiger, Form, beispielsweise aus Kupfer oder Aluminium, das den gleichen Durchmesser aufweist.

Dies hat den besonderen Vorteil, dass wiederum eine optimale Symmetrie der beiden Wicklungen in Bezug auf die resultierenden Magnetfelder erreicht wird.

In einer vorteilhaften Ausgestaltung der Erfindung sind die Spulen durch eine elektrische Zweidrahtleitung gebildet. Beispielsweise wird der Reedschalter mit einer Zweidrahtleitung bewickelt.

Dies hat den besonderen Vorteil, dass eine besonders einfache und zudem symmetrische Realisierung eines erfindungsgemäßen Differenzstromsensors ermöglicht wird.

In einer vorteilhaften Ausgestaltung der Erfindung sind der Spulenbeginn der ersten und zweiten Spule an einem ersten Ende des Reedschalters und das Spulenende der ersten und zweiten Spule an einem zweiten Ende des Reedschalters angeordnet. Dies hat den besonderen Vorteil, dass einerseits die resultierenden Magnetfelder für die Funktion richtig orientiert sind und andererseits an der einen Seite ein energiequellenseitiger Anschluss und an der anderen Seite ein energieverbraucherseitiger Anschluss erfolgen kann.

In einer vorteilhaften Ausgestaltung der Erfindung sind beide Spulen, vorzugsweise parallel, nebeneinander mit dem gleichen Wicklungssinn angeordnet.
Dies hat den besonderen Vorteil, dass eine gute Symmetrie der entstehenden Magnetfelder erreicht wird.

In einer vorteilhaften Ausgestaltung der Erfindung ist der der ersten Spule ein erster Widerstand und der zweiten Spule ein zweiter Widerstand parallel geschaltet.
Dies hat den besonderen Vorteil, dass eine individuelle Anpassung des Differenzstromsensors an verschiedene Stromkreise bzw. Netzspannungen möglich ist. Dadurch ist ein "standardisierter" Differenzstromsensor möglich, der durch die parallelen Widerstände für verschiedene Stromkreise einsetzbar ist.

In einer vorteilhaften Ausgestaltung der Erfindung sind die Kontakte des Reedschalters im stromlosen Zustand geöffnet. Dies hat den besonderen Vorteil, dass im Normalzustand in einem möglichen Auslösekreis kein Strom fließt, so dass ein besonders energiesparsamer Betrieb möglich ist.

In einer vorteilhaften Ausgestaltung der Erfindung sind die Kontakte des Reedschalters mit einem Auslösestromkreis verbunden, der bei geschlossenem Kontakt des Reedschalters den elektrischen Stromkreis unterbricht.

Dies hat den besonderen Vorteil, dass eine Fehlerstromschutzschalterfunktion ermöglicht wird.

In einer vorteilhaften Ausgestaltung der Erfindung weist der Auslösestromkreis eine Auslöseeinheit auf, die mindestens einen, alternativ zwei, im elektrischen Stromkreis angeordneten Kontakt aufweist, zur Unterbrechung des elektrischen Stromkreises.
Dies hat den besonderen Vorteil, dass eine galvanische Trennung des elektrischen Stromkreises bei Überschreiten einer Stromdifferenz erzielbar ist.

In einer vorteilhaften Ausgestaltung der Erfindung ist der elektrische Stromkreis ein Gleichstromkreis.
Dies hat den besonderen Vorteil, dass erstmals eine Möglichkeit für einen Differenzstromsensor für Gleichstromkreise angegeben ist, der insbesondere vorteilhafterweise netzspannungsunabhängig arbeitet.

Mit dem erfindungsgemäßen Differenzstromsensor lässt sich ein Fehlerstromschutzschalter realisieren, insbesondere für Gleichstromkreise. Ferner kann ein solcher Fehlerstromschutzschalter netzspannungsunabhängig sein, d.h. kein eigenes Netzteil für eine Differenzstromauswertung aufweisen.

Erfindungsgemäß ist ferner ein Verfahren umfasst, mit dem elektrische Stromkreise geschützt werden können, insbesondere Gleichstromkreise, mit einem ersten und einem zweiten Leiter, wobei der erste Leiter eine erste Spule und der zweite Leiter eine zweite Spule aufweist, beide Spulen auf einen Reedschalter angeordnet sind, dessen Kontakt mit einem Auslösestromkreis zur Unterbrechung des elektrischen Stromkreises verbunden ist.
Bei einem Überschreiten einer ersten Stromdifferenz zwischen ersten und zweiten Leiter bewirkt das resultierende Magnetfeld beider Spulen einen Kontaktschluss des Reedschalters, wodurch eine Unterbrechung des elektrischen Stromkreises möglich ist.

Alle Ausgestaltungen, sowohl in abhängiger Form rückbezogen auf den Patentanspruch 1 als auch rückbezogen lediglich auf einzelne Merkmale oder Merkmalskombinationen von Patentansprüchen, bewirken eine Verbesserung eines Differenzstromsensors.

Die beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit der Zeichnung näher erläutert werden.

Dabei zeigt die Zeichnung:
Figur 1 eine Darstellung eines bekannten Fehlerstromschutzschalters
Figur 2 eine erste Darstellung eines Reedschalters
Figur 3 eine zweite Darstellung eines Reedschalters
Figur 4 eine Darstellung eines erfindungsgemäßen Differenzstromsensors
Figur 5 eine erste Darstellung einer möglichen Realisierung eines erfindungsgemäßen Fehlerstromschutzschalters
Figur 6 eine dritte Darstellung eines Reedschalters
Figur 7 eine vierte Darstellung eines Reedschalters
Figur 8 eine zweite Darstellung einer möglichen Realisierung eines erfindungsgemäßen Fehlerstromschutzschalters
Figur 9 eine dritte Darstellung einer möglichen Realisierung eines erfindungsgemäßen Fehlerstromschutzschalters
Figur 10 eine vierte Darstellung einer möglichen Realisierung eines erfindungsgemäßen Fehlerstromschutzschalters

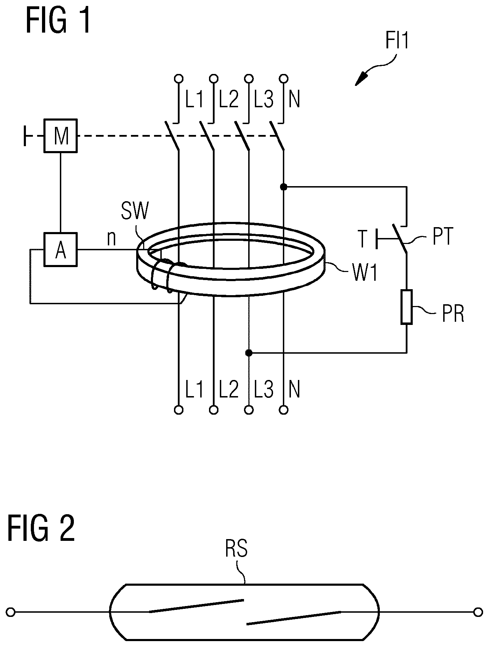

Figur 1 zeigt eine Darstellung eines bekannten netzunabhängigen Fehlerstromschutzschalters FI1, aufweisend einen Summenstromwandler W1, durch den 4 Leiter L1, L2, L3, N eines Dreiphasenwechselstromkreises geführt sind. Der Summenstromwandler weist eine Sekundärwicklung SW auf, die mit einem Auslösekreis A verbunden ist. Dieser ist wiederum mit einer Mechanik M zur Unterbrechung von Kontakten des elektrischen (Dreiphasenwechsel-)Stromkreises verbunden. Der Fehlerstromschutzschalter weist eine Serienschaltung eines Prüfwiderstandes PR und einer Prüftaste PT auf, zur Prüfung der Funktionsfähigkeit des Fehlerstromschutzschalters. Die Serienschaltung ist vor dem Summenstromwandler W1 mit einem Leiter, beispielsweise gemäß Figur 1 mit dem Leiter L3, und nach dem Summenstromwandler W1 mit dem Neutralleiter N verbunden.
Ist die Stromsumme gleich null, d.h. liegt am energiesenkenseitigen Anschluss des Fehlerstromschutzschalters kein Fehler vor, indem Strom am Fehlerstromschutzschalter vorbei abfließt, wird in der Sekundärwicklung des Summenstromwandlers keine Spannung bzw. kein Strom induziert und es erfolgt keine Unterbrechung des elektrischen Stromkreises. Liegt ein Fehlerfall vor, d.h. fließt energiesenkenseitig Strom ab, ist die Stromsumme durch den Summenstromwandler ungleich null. Dadurch wird eine Spannung bzw. ein Strom in der Sekundärwicklung SW induziert, die in der Folge den elektrischen Stromkreis unterbricht.

Figur 2 zeigt eine erste Darstellung eines Reedschalters RS respektive eines durch ein Magnetfeld betätigten Schaltelementes. Ein Reedschalter RS besteht aus mindestens zwei ferromagnetischen Kontakten bzw. Schaltzungen, die i.d.R. hermetisch dicht verschlossen in ein Glasröhrchen eingeschmolzen sind. Die Schaltzungen überlappen sich und haben im offenen Zustand einen geringen Abstand zueinander. Wirkt ein Magnetfeld auf den Reedschalter RS, bewegen sich die beiden Schaltzungen bzw. Paddel aufeinander zu und der Schalter schließt.

Üblicherweise sind diese Schalter als z.B. Öffner, Schließer oder Wechsler ausgeführt. Ist das durch einen Permanentmagneten oder eine Spule erzeugte Magnetfeld stärker als die Federwirkung der Schaltzungen, schließen die beiden Kontakte.

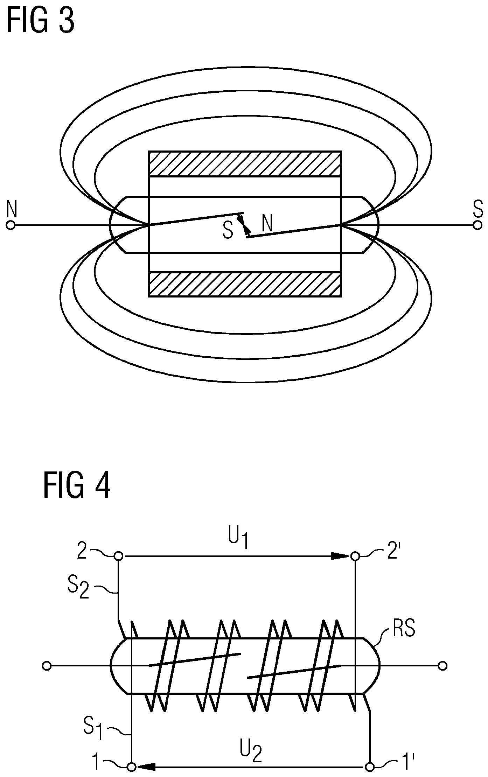

Figur 3 zeigt eine Darstellung gemäß Figur 2, mit dem Unterschied, dass ein Magnetfeld eingezeichnet ist, dass ein Schließen der Schaltzungen bewirken soll. Das Magnetfeld wird in dieser Figur 3 durch einen Elektromagneten, also ein durch die Spulen des Differenzstromsensors erzeugtes Magnetfeld, erzeugt.

Figur 4 zeigt eine Darstellung eines erfindungsgemäßen Differenzstromsensors mit dem Reedschalter RS, der mit einer ersten Spule S1 und einer zweiten Spule S2 bewickelt ist. Die beiden Spulen können bevorzugterweise parallel nebeneinander gewickelt sein. Sie können ferner die gleiche Windungszahl aufweisen. Beide Spulen können aus dem gleichen Material, wie Draht, sein. Beide Spulen können den gleichen Materialquerschnitt bzw. Drahtquerschnitt aufweisen. Das Material kann beispielsweise Kupfer oder Aluminium sein. Der Querschnitt kann rund, eckig, wie rechteckig oder quadratisch, sein. Die Spulen können den gleichen Wicklungssinn aufweisen.

Die Spulen können aber auch gegenläufig gewickelt sein bzw. komplett unterschiedlich sein. Wichtig ist das resultierende Magnetfeld auf den Reedschalter.

In einem geschlossenen Stromkreis, insbesondere Gleichstromkreis, sollen sich die Magnetfelder der beiden Spulen aufheben. Fließt, auf Grund eines Fehlers, in einem der beiden Leiter ein geringerer Strom als im anderen Leiter, bewirkt dies unterschiedlich große Magnetfelder, die sich folglich nicht mehr aufheben, also in Summe nicht mehr null oder annähernd null sind. Das durch die Stromdifferenz resultierende Magnetfeld bewirkt bei Überschreiten einer ersten Stromdifferenz, d.h. bei Überschreiten einer ersten resultierenden Magnetfeldstärke, ein Schließen des Kontaktes des Reedschalters. Hierdurch kann ein zu schützender elektrischer Stromkreis unterbrochen werden.

Ist der Reedschalter bzw. Magnetschalter mit mindestens 2 Spulen bewickelt, so ergibt sich bei Bestromung das resultierende Magnetfeld aus dem Summenstrom beider Spulen. Liegt das resultierende Magnetfeld über dem erforderlichen Maß zum Schließen der Kontakte, so werden diese geschlossen, solange bis das Magentfeld wieder unter ein bestimmtes Maß abfällt.

Die erste Spule S1 hat an einem ersten Ende seinen Spulenbeginn 1 und an einem zweiten Ende des Reedschalters sein Spulenende 2. Die zweite Spule S2 kann am gleichen ersten Ende seinen Spulenbeginn 2 und am gleichen zweiten Ende des Reedschalters sein Spulenende 2 aufweisen.

Der Differenzstromsensor gemäß Figur 4 kann teilweise oder vollständig mit einem Magnetfeldabschirmenden bzw. Magnetfelddämpfenden Material umgeben sein, um Beeinflussungen des Magnetfeldes der Spule durch externe Magnetfelder zu vermeiden. Beispielsweise kann der Differenzstromsensor mit ferromagnetischem Material umgeben sein, wie beispielsweise Eisen, Nickel oder Cobalt bzw. Legierungen derselben, auch Legierungen derselben mit anderen Elementen, wie beispielsweise Edelstähle, die mindestens eins der genannten Elemente enthalten.

Die Magnetfeldabschirmende bzw. -dämpfende Abschirmung kann beispielsweise mehrlagig, durch mehrere Schichten ausgeführt sein. Sie kann zwischen den Schichten Luftspalte bzw. Luftisolierungen enthalten. Die Abschirmung kann auch aus Schichten unterschiedlicher Materialen gebildet sein.

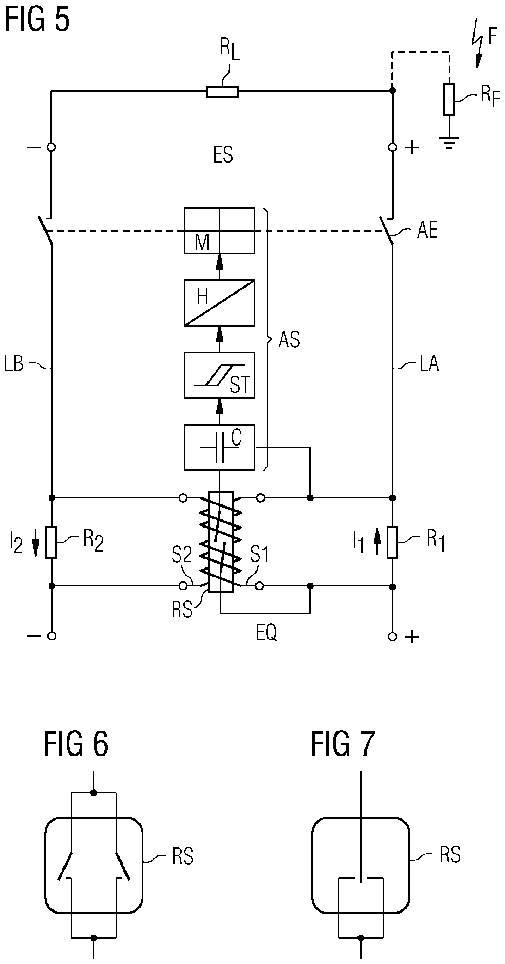

Figur 5 zeigt eine Darstellung einer möglichen Realisierung eines erfindungsgemäßen Fehlerstromschutzschalters. Dieser weist einer erfindungsgemäßen Differenzstromsensor RS auf, dessen erste Spule S1 einem ersten Leiter LA zugeordnet ist, im Beispiel im Strompfad des ersten Leiters LA angeordnet ist.
Die zweite Spule S2 ist einem zweiten Leiter LB zugeordnet, im Beispiel im Strompfad des zweiten Leiters LB angeordnet. Der erste und zweite Leiter LA, LB bilden einen elektrischen Stromkreis. Sie sind einerseits mit einer Energiequelle EQ verbunden und andererseits am energiesenkenseitigen Anschluss ES mit einem Verbrauch RL.
Den beiden Spulen S1, S2 kann ein Widerstand R1, R2 parallel geschaltet sein, wie in Figur 5 gezeigt. Es muss aber nicht.

Die Kontakte des Reedschalters RS sind mit einem Auslösestromkreises AS verbunden, zur Unterbrechung des elektrischen Stromkreises der ersten und zweiten Leiter LA, LB. Der Auslösestromkreis AS kann eine Auslöseeinheit AE aufweisen, mit mechanischen Kontakten, wobei mindestens ein Kontakt vorgesehen sein sollte, zur Unterbrechung des elektrischen Stromkreises der ersten und zweiten Leiter LA, LB.

Der Kontakt des Reedschalters RS kann einerseits mit einem elektrischen Leiter, beispielsweise dem ersten elektrischen Leiter LA, am energiequellenseitigen Anschluss EQ verbunden sein. Der zweite Kontakt des Reedschalters RS kann andererseits mit dem Auslösestromkreis AS verbunden sein, der wiederum mit dem zweiten Leiter LB verbunden ist. Alternativ kann, bei Verwendung von parallelen Widerständen, der Auslösekreis mit dem energiesenkenseitigem Anschluss des Widerstandes verbunden sein, so dass der Spannungsabfall über einem Widerstand für die Energieversorgung des Auslösestromkreises verwendet wird.

Bei einem Gleichstromkreis, wo häufig der Minuspol geerdet ist, und Abgriff über einem Widerstand, sollte der Abgriff über dem Widerstand der Plusleitung erfolgen, da im Fehlerfall der Spannungsabfall hier in der Regel höher ist. Hierbei sollte natürlich die Erdung des Minuspols vor der Einspeisung des erfindungsgemäßen Fehlerstromschutzschalters erfolgen, damit das System funktioniert.

Für den Fall, dass Widerstände parallel zu den Spulen geschaltet sind, soll das Wirkprinzip im Folgenden erläutert werden. Sind die Widerstände R1, R2 gleich groß, sind die Spannungsabfälle U1, U2 hierüber bei gleichen Strömen I1, I2 in beiden Leitern LA, LB, d.h. im Normalfall, gleich groß. Die Widerstände können beispielsweise Shunts oder Leiterstücke sein.

Im Fehlerfall, beispielsweise wenn ein Strom über einen Fehlerwiderstand RF, der am energiesenkenseitigen Anschluss ES bzw. am Verbrauch RL auftritt, abfließt, so wird der Strom in einem Leiter ungleich dem Strom in einem anderen Leiter. Dadurch fallen über die Widerstände unterschiedliche Spannungen ab, die wiederum unterschiedliche Magnetfelder erzeugen, d.h. die Magnetfelder kompensieren sich nicht mehr und schließen den Reedschalter RS. Dadurch wird durch den Auslösestromkreis eine Unterbrechung des elektrischen Stromkreises der Leiter LA, LB bewirkt.

An Stelle mindestens zweier Spulen können 3 oder 4 Spulen aufgebracht sein, um in analoger Weise dreiphasige Wechselstromnetze zu schützen.

Der Differenzstromsensor ist dabei so dimensioniert, dass er spätestens bei Erreichen eines vorgegeben Bemessungsfehlerstromes schaltet.

Der Auslösestromkreis kann ferner eine Speicherfunktion aufweisen, beispielsweise mittels eines Ladegliedes und Schmitt-Triggers.

Ebenso können verschiedene Auslösearten, beispielsweise mit einer kombinierten Strommessung, durchgeführt werden, wie schnelle bzw. sofortige Auslösung bei sehr hohen Strömen. Ebenso kann eine gering-verzögerte Auslösung implementiert sein.

Der Auslösestromkreis kann ferner umfassen:
ein Ladeglied C,
einen Schwellwertschalter ST bzw. Schmitt-Trigger,
einen Haltemagnet H,
ein Kontaktsystem oder/und Schaltschloss M.
Durch das Schließen des Reedschalters bei Erreichen einer ersten Stromdifferenz bzw. einer Bemessungsfehlerstromgrenze erfolgt das Schließen des Kontaktes des Reedschalters welches den Energiefluss für das Ladeglied / den Schwellwertschalter zum Auslösen eines herkömmlichen voreingestellten Haltemagneten zum Unterbrechen des Stromkreises bewirkt.

Figur 6 zeigt eine dritte Darstellung eines Reedschalters RS respektive eines durch ein Magnetfeld betätigten Schaltelementes. Dieser weist zwei Schließer bzw. Schließer-Kontakte auf, wobei der erste Schließer durch ein erstes Magnetfeld geschlossen wird und der zweite Schließer durch ein zweites, entgegengesetzt gerichtetes Magnetfeld geschlossen wird. Beispiels kann der erste Schließer durch ein Nord-Süd gerichtetes Magnetfeld schließbar sein und der zweite Schließer durch ein Süd-Nord gerichtetes Magnetfeld.

Beide Kontakte sind parallel geschaltet, so dass unabhängig von der Richtung des Magnetfeldes bei Überschreiten einer Magnetfelddifferenz hervorgerufen durch eine Stromdifferenz ein Schließen der Kontakte bzw. Schließer erfolgt.
Dies kann z.B. für polarisationsunabhängige Differenzstromsensoren bzw. Fehlerstromschutzschalter, insbesondere für Gleichstrom, relevant sein. So kann beispielsweise ein polarisationsunabhängiger Gleichstrom-Fehlerstromschutzschalter realisiert werden, d.h. bei welchem egal ist, an welchem Leiteranschluss der Plus- oder Minuspol des zu schützenden Gleichstromkreises angeschlossen ist.

Figur 7 zeigt eine vierte Darstellung eines Reedschalters RS respektive eines durch ein Magnetfeld betätigten Schaltelementes. Dieser weist zwei Kontakte und eine Kontaktzunge auf, die abhängig von der Richtung des Magnetfeldes entweder mit dem ersten Kontakt oder dem zweiten Kontakt in Berührung für einen Stromfluss ist. Der erste Kontakt wird durch ein erstes Magnetfeld geschlossen und der zweite Kontakt durch ein zweites, entgegengesetzt gerichtetes Magnetfeld geschlossen.

Beispiels kann der erste Kontakt durch ein Nord-Süd gerichtetes Magnetfeld schließbar sein und der zweite Kontakt durch ein Süd-Nord gerichtetes Magnetfeld.

Beide Kontakte sind parallel geschaltet, so dass unabhängig von der Richtung des Magnetfeldes bei Überschreiten einer Magnetfelddifferenz hervorgerufen durch eine Stromdifferenz ein Schließen der Kontakte bzw. Schließer erfolgt.

Dies kann ebenfalls für z.B. polarisationsunabhängige Differenzstromsensoren bzw. Fehlerstromschutzschalter, insbesondere für Gleichstrom, relevant sein. So kann beispielsweise ein polarisationsunabhängiger Gleichstrom-Fehlerstromschutzschalter realisiert werden, d.h. bei welchem egal ist, an welchem Leiteranschluss der Plus- oder Minuspol des zu schützenden Gleichstromkreises angeschlossen ist.

Allgemein können neben einem Schließer als Kontakt des Reedschalters auch Umschalter oder Öffner verwendet werden.

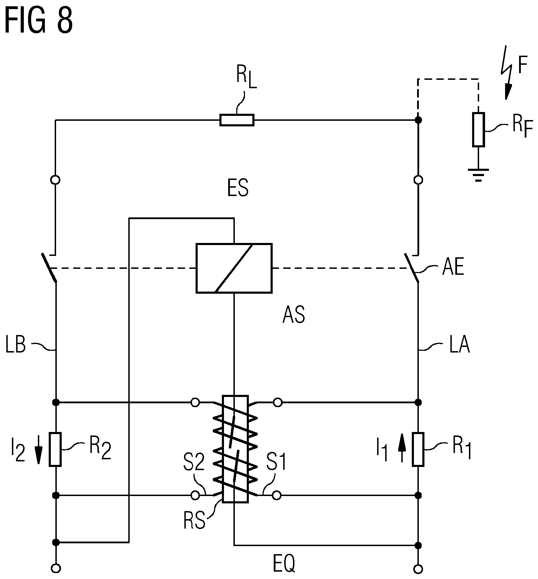

Figur 8 zeigt eine Darstellung einer Realisierung eines Fehlerstromschutzschalters gemäß Figur 5, mit dem Unterschied eines sehr einfachen Auslösestromkreises AS, der in Serie mit dem Kontakt des Differenzstromsensors RS geschaltet ist und dessen Stromversorgung durch die Leiter LA, LB erfolgt.

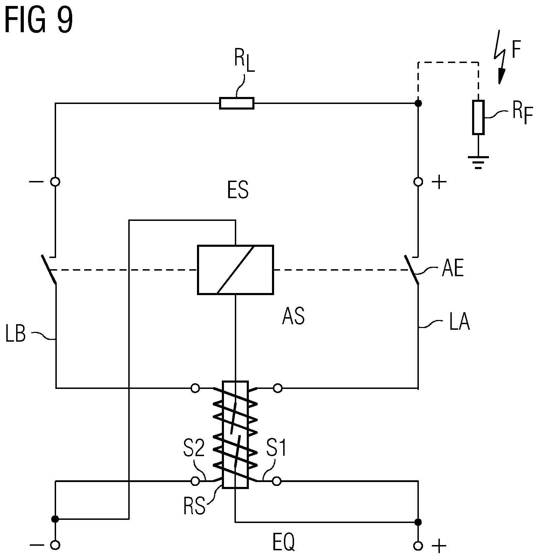

Figur 9 zeigt eine Darstellung gemäß Figur 8, mit dem Unterschied, dass keine parallel geschalteten Widerstände R1, R2 vorhanden sind.

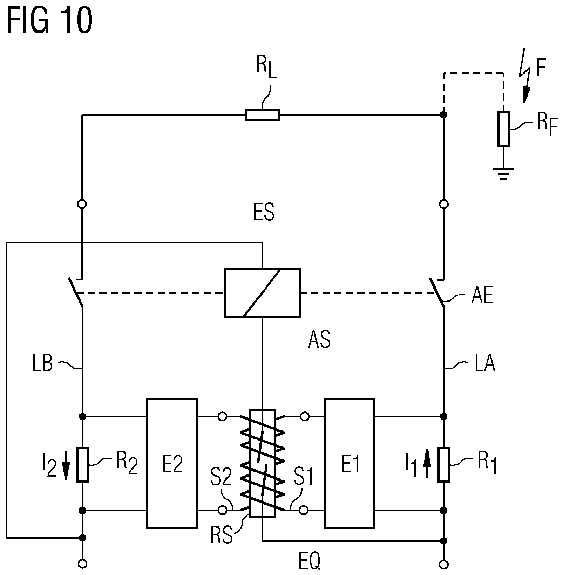

Figur 10 zeigt eine Darstellung gemäß Figur 8, mit dem Unterschied, dass zwischen parallel geschaltetem Widerstand R1, R2 und Spule S1, S2 - wobei der primäre Stromfluss der Leiter LA, LB über die Widerstände R1, R2 erfolgt - jeweils eine Einheit E1, E2 eingefügt ist.

Diese Einheit E1, E2 kann jeweils zum ersten eine Gleichrichtung enthalten, um beispielsweise die Erfindung bei Wechselstromnetzen, insbesondere bei Netzen mit einem großen Frequenzspektrum, einzusetzen. Damit wird den Spulen eine gleichgerichtete Wechselspannung zugeführt. Alternativ kann so auch ein gleich- und wechselspannungsfähiger Fehlerstromschutzschalter realisiert sein.

Die Gleichrichtung kann eine Diode oder mehrere Dioden aufweisen, sowie gegebenenfalls Kondensatoren oder/und Spulen.

Diese Einheit E1, E2 kann zum zweiten ein Filter enthalten, um beispielsweise gezielt Fehler-Wechselströme in bestimmten Frequenzbereichen zu ermitteln. Das Filter kann Spulen oder/und Kondensatoren enthalten. Auch zusätzliche Widerstände sind denkbar.

Diese Einheit E1, E2 kann zum dritten auch eine Kombination aus Gleichrichter und Filter enthalten, um beispielsweise einen bestimmten allstromsensitiven bzw. frequenzselektiven Fehlerstromschutzschalter zu realisieren.

Zusammengefasst lässt sich sagen, dass erfindungsgemäß ein Reed- bzw. Magnetschalter als Summenstromsensor bzw. Differenzstromsensor vorgeschlagen wird. Dieser kann für die netzspannungsunabhängige Messung von Summenströmen in Fehlerstromschutzschaltern, insbesondere für Gleichspannung, vorteilhaft verwendet werden.

Durch die Erfindung wird ein kostengünstiger Aufbau eines Sensors bzw. Fehlerstromschutzschalters ermöglicht. Ferner kann eine hohe Zuverlässigkeit verbunden mit langer Lebensdauer erzielt werden. Der Aufbau kann vollständig mit passiven Komponenten / Bauelementen erfolgen.

Obwohl die Erfindung im Detail durch das Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung, der durch die Ansprüche bestimmt ist, zu verlassen.

## Patentansprüche

1. Differenzstromsensor für einen elektrischen Stromkreis, aufweisend einen Reedschalter (RS), der mit mindestens 2 Spulen (S1,S2) bewickelt ist,
**dadurch gekennzeichnet,**
**dass** die Spulen in den elektrischen Stromkreis, aufweisend einen ersten und einen zweiten Leiter (LA,LB), einfügbar sind, wobei im Gebrauch die erste Spule dem ersten Leiter und die zweite Spule dem zweiten Leiter zugeordnet ist, wobei die Spulen so konfiguriert sind, dass bei einem Überschreiten einer Stromdifferenz im ersten und zweiten Leiter das resultierende Magnetfeld beider Spulen einen Kontaktschluss des Reedschalters bewirkt,
wobei die Leiter eine Energiequelle mit einem Energieverbraucher verbinden.

2. Differenzstromsensor nach Patentanspruch 1,
**dadurch gekennzeichnet,**
**dass** beide Spulen die gleiche Windungszahl aufweisen.

3. Differenzstromsensor nach Patentanspruch 1 oder 2,
**dadurch gekennzeichnet,**
**dass** beide Spulen aus einem elektrisch leitfähigen Material bestehen, das den gleichen Durchmesser aufweist.

4. Differenzstromsensor nach Patentanspruch 1, 2 oder 3,
**dadurch gekennzeichnet,**
**dass** die Spulen durch eine elektrische Zweidrahtleitung gebildet sind.

5. Differenzstromsensor nach Patentanspruch 1, 2, 3 oder 4,
**dadurch gekennzeichnet,**
**dass** der Spulenbeginn der ersten und zweiten Spule an einem ersten Ende des Reedschalters und das Spulenende der ersten und zweiten Spule an einem zweiten Ende des Reedschalters angeordnet sind.

6. Differenzstromsensor nach einem der vorhergehenden Patentansprüche,
**dadurch gekennzeichnet,**
**dass** beide Spulen nebeneinander mit dem gleichen Wicklungssinn angeordnet sind.

7. Differenzstromsensor nach einem der vorhergehenden Patentansprüche,
**dadurch gekennzeichnet,**
**dass** der Spulenbeginn der ersten und zweiten Spule mit der Energiequelle und das Spulenende der ersten und zweiten Spule mit dem Energieverbraucher verbunden sind.

8. Differenzstromsensor nach einem der vorhergehenden Patentansprüche,
**dadurch gekennzeichnet,**
**dass** der ersten Spule ein erster Widerstand (R1) und der zweiten
Spule ein zweiter Widerstand (R2)
parallel geschaltet ist.

9. Differenzstromsensor nach einem der vorhergehenden Patentansprüche,
**dadurch gekennzeichnet,**
**dass** die Kontakte des Reedschalters im stromlosen Zustand geöffnet sind.

10. Differenzstromsensor nach einem der vorhergehenden Patentansprüche,
**dadurch gekennzeichnet,**
**dass** die Kontakte des Reedschalters mit einem Auslösestromkreis (AS) verbunden sind, der bei geschlossenen Kontakt des Reedschalters den elektrischen Stromkreis unterbricht.

11. Differenzstromsensor nach Patentanspruch 10,
**dadurch gekennzeichnet,**
**dass** der Auslösestromkreis eine Auslöseeinheit (AE) aufweist, die mindestens einen im elektrischen Stromkreis angeordneten Kontakt aufweist, zur Unterbrechung des elektrischen Stromkreises.

12. Differenzstromsensor nach einem der vorhergehenden Patentansprüche,
**dadurch gekennzeichnet,**
**dass** der elektrische Stromkreis ein Gleichstromkreis ist.

13. Fehlerstromschutzschalter für einen elektrischen Stromkreis, aufweisend einen Differenzstromsensor nach einem der Patentansprüche 1 bis 12.

14. Verfahren zum Schutz eines elektrischen Stromkreises mit einem ersten und einem zweiten Leiter, wobei der erste Leiter eine erste Spule und der zweite Leiter eine zweite Spule aufweist, beide Spulen auf einem Reedschalter angeordnet sind, dessen Kontakt mit einem Auslösestromkreis zur Unterbrechung des elektrischen Stromkreises verbunden ist,
dass bei einem Überschreiten einer ersten Stromdifferenz im ersten und zweiten Leiter das resultierende Magnetfeld beider Spulen einen Kontaktschluss des Reedschalters bewirkt, wodurch der elektrische Stromkreis unterbrochen wird,
wobei die Leiter eine Energiequelle mit einem Energieverbraucher verbinden.

## Claims

1. Differential current sensor for an electrical circuit, having a reed switch (RS) which is wound with at least two coils (S1, S2),
**characterized**
**in that** the coils can be inserted into the electrical circuit having a first and a second conductor (LA, LB), wherein, during use, the first coil is assigned to the first conductor and second coil is assigned to the second conductor, wherein the coils are configured in such a manner that, if a current difference is exceeded in the first and second conductors, the resulting magnetic field of both coils causes a contact of the reed switch to be closed,
wherein the conductors connect an energy source to an energy consumer.

2. Differential current sensor according to Patent Claim 1,
**characterized**
**in that** both coils have the same number of turns.

3. Differential current sensor according to Patent Claim 1 or 2,
**characterized**
**in that** both coils are composed of an electrically conductive material which has the same diameter.

4. Differential current sensor according to Patent Claim 1, 2 or 3,
**characterized**
**in that** the coils are formed by an electrical two-wire line.

5. Differential current sensor according to Patent Claim 1, 2, 3 or 4,
**characterized**
**in that** the coil beginning of the first and second coils is arranged at a first end of the reed switch and the coil end of the first and second coils is arranged at a second end of the reed switch.

6. Differential current sensor according to one of the preceding patent claims,
**characterized**
**in that** both coils are arranged beside one another with the same winding sense.

7. Differential current sensor according to one of the preceding patent claims,
**characterized**
**in that** the coil beginning of the first and second coils is connected to the energy source and the coil end of the first and second coils is connected to the energy consumer.

8. Differential current sensor according to one of the preceding patent claims,
**characterized**
**in that** a first resistor (R1) is connected in parallel with the first coil and a second resistor (R2) is connected in parallel with the second coil.

9. Differential current sensor according to one of the preceding patent claims,
**characterized**
**in that** the contacts of the reed switch are open in the deenergized state.

10. Differential current sensor according to one of the preceding patent claims,
**characterized**
**in that** the contacts of the reed switch are connected to a trip circuit (AS) which interrupts the electrical circuit when the contact of the reed switch is closed.

11. Differential current sensor according to Patent Claim 10,
**characterized**
**in that** the trip circuit has a trip unit (AE) which has at least one contact, arranged in the electrical circuit, for interrupting the electrical circuit.

12. Differential current sensor according to one of the preceding patent claims,
**characterized**
**in that** the electrical circuit is a DC circuit.

13. Residual current circuit breaker for an electrical circuit, having a differential current sensor according to one of Patent Claims 1 to 12.

14. Method for protecting an electrical circuit having a first and a second conductor, wherein the first conductor has a first coil and the second conductor has a second coil, both coils being arranged on a reed switch, the contact of which is connected to a trip circuit for interrupting the electrical circuit,
wherein, if a first current difference is exceeded in the first and second conductors, the resulting magnetic field of both coils causes a contact of the reed switch to be closed, thus interrupting the electrical circuit,
wherein the conductors connect an energy source to an energy consumer.

## Revendications

1. Capteur de courant différentiel pour un circuit de courant électrique, comprenant un interrupteur à lames souples (RS), qui est entouré avec au moins deux bobines (S1, S2), **caractérisé en ce que** les bobines peuvent être insérées dans le circuit de courant électrique, comprenant un premier et un second conducteurs (LA, LB),
dans lequel, dans l'usage, la première bobine est associée au premier conducteur et la seconde bobine est associée au second conducteur,
dans lequel les bobines sont configurées de telle manière qu'en cas de dépassement d'une différence de courant dans le premier et le second conducteurs, le champ magnétique résultant des deux bobines provoque une fermeture de contact de l'interrupteur à lames souples, et
dans lequel les conducteurs relient une source d'énergie à un consommateur d'énergie.

2. Capteur de courant différentiel selon la revendication 1, **caractérisé en ce que** les deux bobines comprennent le même nombre de spires.

3. Capteur de courant différentiel selon la revendication 1 ou 2, **caractérisé en ce que** les deux bobines sont constituées d'un matériau électriquement conducteur, qui a le même diamètre.

4. Capteur de courant différentiel selon la revendication 1, 2 ou 3, **caractérisé en ce que** les bobines sont formées par une ligne bifilaire électrique.

5. Capteur de courant différentiel selon la revendication 1, 2, 3 ou 4, **caractérisé en ce que** le début de bobine de la première et de la seconde bobines est disposé à une première extrémité de l'interrupteur à lames souples et la fin de bobine de la première et de la seconde bobines est disposée à une seconde extrémité de l'interrupteur à lames souples.

6. Capteur de courant différentiel selon l'une des revendications précédentes, **caractérisé en ce que** les deux bobines sont disposées à côté l'une de l'autre avec le même sens d'enroulement.

7. Capteur de courant différentiel selon l'une des revendications précédentes, **caractérisé en ce que** les débuts de bobine de la première et de la seconde bobine sont reliés à la source d'énergie et les fins de bobine de la première et de la seconde bobine sont reliées au consommateur d'énergie.

8. Capteur de courant différentiel selon l'une des revendications précédentes, **caractérisé en ce qu'**une première résistance (R1) est connectée en parallèle à la première bobine ainsi qu'une seconde résistance (R2) à la seconde bobine.

9. Capteur de courant différentiel selon l'une des revendications précédentes, **caractérisé en ce que** les contacts de l'interrupteur à lames souples sont ouverts dans l'état sans courant.

10. Capteur de courant différentiel selon l'une des revendications précédentes, **caractérisé en ce que** les contacts de l'interrupteur à lames souples sont reliés à un circuit de courant de déclenchement (AS), qui interrompt le circuit de courant électrique en cas de contact fermé de l'interrupteur à lames souples.

11. Capteur de courant différentiel selon la revendication 10, **caractérisé en ce que** le circuit de courant de déclenchement comprend une unité de déclenchement (AE), qui comprend au moins un contact disposé dans le circuit de courant électrique, pour interrompre le circuit de courant électrique.

12. Capteur de courant différentiel selon l'une des revendications précédentes, **caractérisé en ce que** le circuit de courant électrique est un circuit de courant continu.

13. Disjoncteur de protection à courant de défaut pour un circuit de courant électrique, comprenant un capteur de courant différentiel selon l'une des revendications 1 à 12.

14. Procédé pour protéger un circuit de courant électrique comprenant un premier et un second conducteurs, dans lequel le premier conducteur comprend une première bobine et le second conducteur comprend une seconde bobine, les deux bobines sont disposées sur un interrupteur à lames souples, dont le contact est relié à un circuit de courant de déclenchement pour interrompre le circuit de courant électrique,
de telle manière qu'en cas de dépassement d'une première différence de courant dans le premier et le second conducteurs, le champ magnétique résultant des deux bobines provoque une fermeture de contact de l'interrupteur à lames souples, au moyen de quoi le circuit de courant électrique est interrompu,
dans lequel les conducteurs relient une source d'énergie à un consommateur d'énergie.
